(19) Europäisches Patentamt
European Patent Office
Office européen des brevets

(11) **EP 4 715 311 A1**

(12) **EUROPEAN PATENT APPLICATION**
published in accordance with Art. 153(4) EPC

(43) Date of publication:
**25.03.2026 Bulletin 2026/13**

(21) Application number: **24855356.2**

(22) Date of filing: **13.05.2024**

(51) International Patent Classification (IPC):
**F28D 15/04** (2006.01)    **H05K 7/20** (2006.01)

(52) Cooperative Patent Classification (CPC):
**F28D 15/046; F28D 15/0233; F28D 15/04**

(86) International application number:
**PCT/CN2024/092878**

(87) International publication number:
**WO 2025/039626 (27.02.2025 Gazette 2025/09)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **18.08.2023 CN 202311053013**

(71) Applicant: **ZTE CORPORATION
Shenzhen, Guangdong 518057 (CN)**

(72) Inventors:
• SUN, Zhen
 Shenzhen, Guangdong 518057 (CN)
• BAI, Hongwei
 Shenzhen, Guangdong 518057 (CN)
• XU, Qingsong
 Shenzhen, Guangdong 518057 (CN)

(74) Representative: **Cristinelli, Luca et al
Jacobacci & Partners S.p.A.
Corso Emilia, 8
10152 Torino (IT)**

(54) **VAPOR CHAMBER AND HEAT DISSIPATION APPARATUS**

(57)    The embodiments of the present disclosure provide a vapor chamber and a heat dissipation apparatus. The vapor chamber comprises: an evaporation capillary structure; a condensation capillary structure, the middle thickness of the condensation capillary structure being larger than the peripheral thickness of the condensation capillary structure; and a capillary column structure, connected between the evaporation capillary structure and the condensation capillary structure, and used for enabling a liquid working medium to flow black to the evaporation capillary structure along the capillary column structure.

Fig. 1

## Description

## Cross-Reference to Related Application

This disclosure is based on Chinese patent application CN 202311053013.0 filed on August 18, 2023 and entitled "Vapor Chamber and Heat Dissipation Apparatus", and claims the priority based on this patent application, the disclosure of which is incorporated herein by reference in its entirety.

## Technical Field

The present disclosure relates to the field of heat dissipation for electronic devices, and in particular to a vapor chamber and a heat dissipation apparatus.

## Background

With the rapid development of the communication and electronics industry, the integration level of electronic products is becoming higher and higher, causing power consumption and heat-flux density to keep climbing, which brings severe challenges to heat dissipation technology. The vapor chamber (VC) is widely used in the field of electronic heat dissipation due to its high heat transfer efficiency. The vapor chamber is mainly composed of a housing, a capillary structure, and a working fluid water, and its working principle mainly involves utilizing the continuous phase change and circulation of the working fluid water to transfer heat from a heat source of a chip to the external environment.

The current VC technology has two problems: under high-power, high-heat-flux scenarios, the liquid working fluid inside the capillary structure of the core evaporator zone above the heat source inside the VC is vaporized and cannot be replenished in time, leading to dry-out of the capillary structure and failure of the performance of the VC. Although increasing the thickness of the capillary structure or the amount of working fluid can prevent dry-out, an excessive thickness of the capillary structure or an excessive amount of the working fluid results in high evaporation thermal resistance, making the performance of the VC insufficient to meet heat dissipation requirements.

In summary, there is still no effective solution for the problems of dry-out of the capillary structure or excessive evaporation thermal resistance in vapor chambers in the prior art.

## Summary

Embodiments of the present disclosure provide a vapor chamber and a heat dissipation apparatus, so as to at least solve the problems of dry-out of the capillary structure or excessive evaporation thermal resistance in vapor chambers in the prior art.

According to one embodiment of the present disclosure, a vapor chamber is provided. The vapor chamber includes: an evaporation capillary structure; a condensation capillary structure, a central thickness of the condensation capillary structure being greater than a peripheral thickness of the condensation capillary structure; and a capillary column structure, connected between the evaporation capillary structure and the condensation capillary structure, and used for allowing a liquid working fluid to return to the evaporation capillary structure along the capillary column structure.

According to another embodiment of the present disclosure, a heat dissipation apparatus is provided. The heat dissipation apparatus includes one or more vapor chambers according to any of the described embodiments.

## Brief Description of the Drawings

Fig. 1 is a schematic diagram of the capillary structure of a vapor chamber according to an embodiment of the present disclosure;

Fig. 2 is a schematic diagram of the structure of a vapor chamber according to another embodiment of the present disclosure;

Fig. 3 is a schematic diagram of the structure of a vapor chamber according to yet another embodiment of the present disclosure;

Fig. 4 is a top view of a lower shell having a groove array structure according to an embodiment of the present disclosure;

Fig. 5 is a schematic diagram of a working fluid circulation path in the vapor chamber according to an embodiment of the present disclosure;

Fig. 6 is a schematic diagram of the structure of a vapor chamber in a vertical installation scenario according to an embodiment of the present disclosure.

In the drawings: evaporation capillary structure 11, capillary column structure 12, condensation capillary structure 13, upper shell 14, lower shell 15, support column 16, heat source 17, and groove array structure 18.

## Detailed Description of the Embodiments

Embodiments of the present disclosure will be described below in detail with reference to the accompanying drawings and in conjunction with embodiments.

It should be noted that, terms such as "first" and "second" in the description, claims, and accompanying drawings of the present disclosure are used to distinguish similar objects, but are not necessarily used to describe a specific sequence or order.

Embodiments of the present disclosure provide a vapor chamber and a heat dissipation apparatus. The vapor chamber includes: an evaporation capillary structure; a condensation capillary structure, a central thickness of the condensation capillary structure being greater than a peripheral thickness of the condensation capillary structure; and a capillary column structure, connected between the evaporation capillary structure and the condensation capillary structure, and used for allowing a liquid working fluid to return to the evaporation capillary structure along the capillary column structure. Through the embodiments of the present disclosure, the problems of dry-out of the capillary structure or excessive evaporation thermal resistance in vapor chambers in the prior art can be solved, the evaporation thermal resistance can be reduced, accelerating the circulation and heat dissipation efficiency of the phase-change working fluid, preventing dry-out of the capillary structure, and improving the heat transfer capability of the vapor chamber.

According to an embodiment of the present disclosure, a vapor chamber is provided.

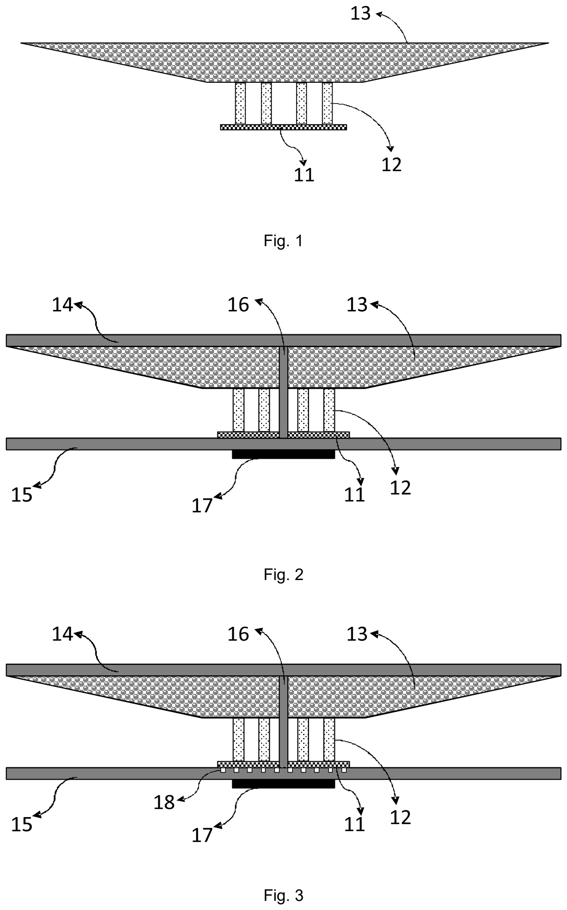

Fig. 1 is a schematic diagram of the capillary structure of a vapor chamber according to an embodiment of the present disclosure. As shown in Fig. 1, the vapor chamber includes the following structure: an evaporation capillary structure 11, a capillary column structure 12, and a condensation capillary structure 13.

In the present embodiment, the evaporation capillary structure 11 is used for evaporating a liquid working fluid into a vapor working fluid under the heat of a heat source. The evaporation capillary structure 11 can be designed as a thin capillary structure layer, thereby reducing evaporation thermal resistance by reducing the thickness of a liquid film.

In the present embodiment, a central thickness of the condensation capillary structure 13 is greater than a peripheral thickness of the condensation capillary structure, forming a "converging-type" capillary structure. The "converging-type" condensation capillary structure 13 can gather the condensed liquid working fluid in the central region of the condensation capillary structure, i.e. directly above the core evaporation region, and has the function of a "liquid reservoir", continuously supplying the liquid working fluid to the evaporation capillary structure, thereby preventing dry-out of the evaporation capillary structure due to insufficient liquid replenishment under high power conditions.

In the present embodiment, the capillary column structure 12 is connected between the evaporation capillary structure 11 and the condensation capillary structure 13, and is used for allowing the liquid working fluid to return to the evaporation capillary structure along the capillary column structure. The capillary column structure can shorten the liquid return path, accelerate the return flow speed of the liquid working fluid, and further prevent dry-out of the evaporation capillary structure.

Through the embodiments of the present disclosure, the supply of the circulating working fluid is secured, preventing dry-out of the capillary structure, while also reducing evaporation thermal resistance and enhancing the heat transfer capability of the vapor chamber, thereby solving the problems of dry-out of the capillary structure or excessive evaporation thermal resistance in vapor chambers in the prior art.

In the embodiments of the present disclosure, on the basis of securing the supply of liquid working fluid to the capillary structure and preventing dry-out of the capillary structure, the evaporation capillary structure can be designed as a thin capillary structure layer, thereby reducing the thickness of the liquid film and thus reducing the evaporation thermal resistance.

In an exemplary embodiment, the thickness of the evaporation capillary structure can be designed according to power consumption requirements, materials and processing cost, and the thickness can be designed to be several tens of micrometers to several millimeters.

In some embodiments, there may be one or more capillary column structures 12. By increasing the number of capillary column structures 12, the return speed of the liquid working fluid can be further accelerated. Further, the capillary column structure is arranged directly above the evaporation capillary structure.

In the embodiments of the present disclosure, the condensed liquid returns through the capillary column structure and evaporates in the evaporation region, so that the liquid return path can be separated from the evaporation path. This facilitates the escape of vapor, improves circulation efficiency, and reduces thermal resistance.

In some embodiments, the area of the condensation capillary structure is larger than the area of the evaporation capillary structure. This can further promote condensation of the liquid working fluid and increase the heat dissipation rate of the vapor chamber.

In some embodiments, the evaporation capillary structure, the capillary column structure and the condensation capillary structure are made of one of the following: sintered copper powder, copper mesh, grooves, or fiber bundles.

Further, the evaporation capillary structure, the capillary column structure and the condensation capillary structure may also be made from other porous materials, which is not limited in the present disclosure. The capillary structure in the embodiments of the present disclosure is simpler, which can eliminate the need for complex capillary processing techniques, thereby reducing production cost.

In some embodiments, the condensation capillary structure is in the shape of a truncated pyramid or a truncated cone, wherein the upper surface of the condensation capillary structure is greater than the lower surface of the condensation capillary structure.

In the embodiments of the present disclosure, the condensed capillary structure is designed to be a "converging-type" structure with a larger upper portion and a smaller lower portion, so that the condensed liquid working fluid can gather in the central region of the condensation capillary structure, i.e. directly above the evaporation capillary structure. This structure serves as a "liquid reservoir", supplying the evaporation capillary structure with liquid working fluid and preventing dryout within the evaporation capillary structure due to insufficient liquid replenishment under high power conditions.

Fig. 2 is a schematic diagram of the structure of a vapor chamber according to another embodiment of the present application. As shown in Fig. 2, in addition to the evaporation capillary structure 11, the capillary column structure 12 and the condensation capillary structure 13 according to any one of the described embodiments, the vapor chamber further includes the following structures: an upper shell 14, a lower shell 15 and a support column 16.

In the present embodiment, the upper shell 14 is connected to the upper surface of the condensation capillary structure.

In the present embodiment, one side of the lower shell 15 is connected to the lower surface of the evaporation capillary structure, and the other side of the lower shell 15 is connected to a heat source 17.

In the present embodiment, the support column 16 is connected between the lower shell 15 and the upper shell 14.

In some embodiments, an area of the evaporation capillary structure is greater than an area of the heat source. The area of the evaporation capillary structure can cover the area of the entire heat source, ensuring effective heat transfer from the heat source.

In an exemplary embodiment, the area of the evaporation capillary structure may be 10% to 50% greater than the area of the heat source, but the present disclosure is not limited thereto.

In some embodiments, a material of the lower shell and the upper shell include one of the following: a metal, an alloy, or a composite material. Further, the lower shell and the upper shell may also be made of other high thermal conductivity materials, so as to ensure effective heat transfer and dissipation.

In some embodiments, a sealed cavity may be formed between the lower shell and the upper shell, so as to prevent the vapor working fluid from leaking, and to ensure that the vapor working fluid can condense in the condensation capillary structure. The space within the sealed cavity, excluding the capillary structures, serves as the flow path for the vapor working fluid. In the schematic diagrams of various embodiments of the present disclosure, only the core structures of the vapor chamber are shown, and the complete vapor chamber structure is not is not illustrated.

Further, a sealed cavity may be formed between the lower shell and the upper shell by means of diffusion welding, brazing, laser welding, or other welding processes, and the support column(s) may additionally be provided to prevent collapse of the cavity.

In some embodiments, the condensation capillary structure is bonded to the upper shell by sintering, Computer Numerical Control (CNC) machining, etching, or other processes, and is formed into a structure with a thicker central region and thinner peripheral region by means of a specifically shaped mould, machining, or other processes. The evaporation capillary structure is bonded to the lower shell by sintering, CNC, etching, or other processes.

Fig. 3 is a schematic diagram of the structure of a vapor chamber according to yet another embodiment of the present disclosure. As shown in Fig. 3, a side of the lower shell 15 in contact with the evaporation capillary structure 11 is provided with a groove array structure 18 composed of a plurality of grooves.

In the present embodiment, the groove array structure 18 is located directly below the evaporation capillary structure 11, with both having substantially the same area.

In some embodiments, the arrangement manner of the groove array structure includes one of the following: a dotted array, a striped array, or a crossed array; and the shape of the grooves includes one of the following: triangular, circular, or rectangular.

The groove array structure in the embodiments of the present disclosure can also be designed in other shapes or arrangement manners. The groove array structure can increase the evaporation/boiling heat dissipation area and increase the number of vaporization cores, thereby improving phase-change heat transfer.

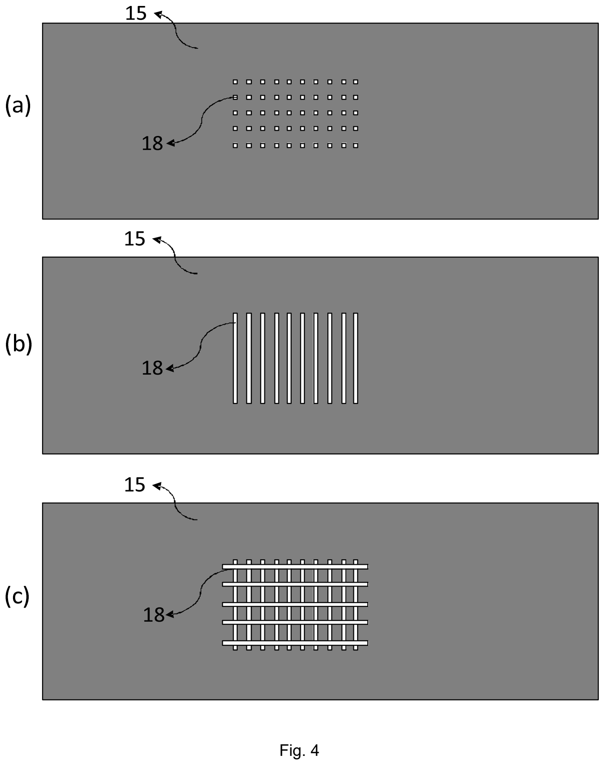

Fig. 4 is a top view of a lower shell having a groove array structure according to an embodiment of the present disclosure. As shown in Fig. 4, the groove array structure 18 is located at the central position of the lower shell 15, and specifically, may be designed according to the position of the evaporation capillary structure 11.

In the present embodiment, the arrangement manner of the groove array structure may include, but is not limited to, the following:

(a) dotted array, (b) striped array, (c) crossed array.

Further, the grooves in the striped array and the crossed array are elongated in shape, including but not limited to straight grooves, curved grooves, or similar shapes. In the dotted array, the shape of each groove includes but is not limited to triangular, circular, rectangular, or similar shapes.

In the embodiments of the present disclosure, by providing a groove array structure on the lower shell, the evaporation/boiling heat dissipation area can be increased, and the number of the vaporization cores can be increased, thereby improving phase-change heat transfer.

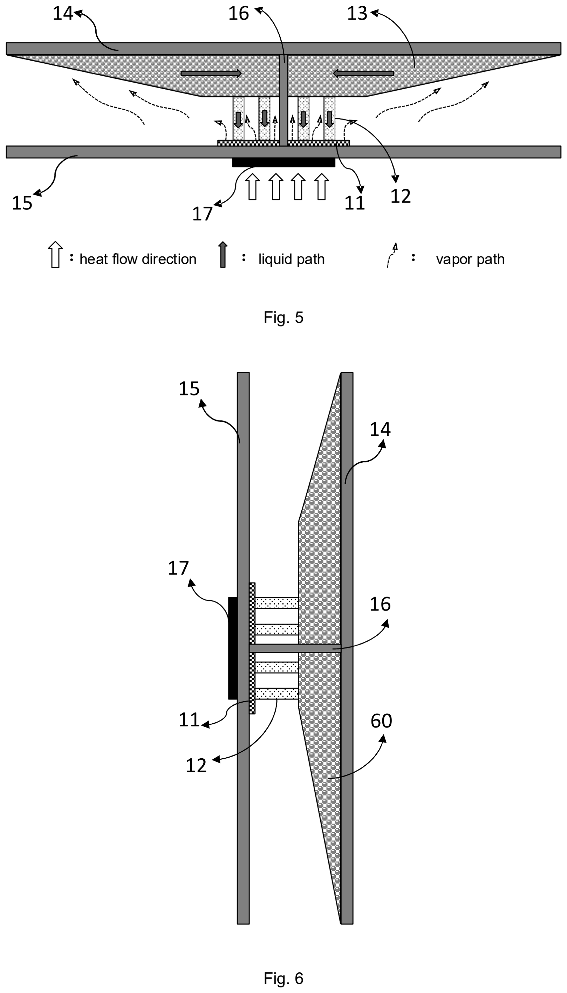

Fig. 5 is a schematic diagram of a working fluid circulation path in the vapor chamber according to an embodiment of the present disclosure. As shown in Fig. 5, the vapor working fluid and liquid working fluid within the vapor chamber flow along their respective vapor paths and liquid paths, separated from each other, so that the flow resistance of both the vapor and liquid working fluids is reduced, and the circulation efficiency of the working fluid is increased.

In the present embodiment, heat is introduced from a heat source 17 and conducted through the lower shell 15 to the evaporation capillary structure 11. Liquid working fluid in the evaporation capillary structure is evaporated into vapor working fluid by the heat from the heat source 17. The vapor working fluid rises along vapor paths outside the capillary column structure 12 to the condensation capillary structure 13. The condensation capillary structure transfers heat through the upper shell 14 to the air, heat dissipation fins, or other heat dissipation apparatuses for cooling. The vapor working fluid is condensed into liquid working fluid at the condensation capillary structure. Under the influence of gravity, the liquid working fluid inside the condensation capillary structure gathers at the central-lower part of the condensation capillary structure, and flows back along the capillary column structure (i.e., the liquid path) to the evaporation capillary structure for the next evaporation cycle. By means of the phase-change circulation of the working fluid, the heat from the heat source can be taken away, achieving heat dissipation.

In the present embodiment, the condensation capillary structure may function as a "liquid reservoir", supplying liquid working fluid to the evaporation capillary structure, and preventing dry-out within the evaporation capillary structure due to insufficient liquid replenishment under high power conditions. The capillary column structure can shorten the liquid return path, accelerate the return flow speed of the liquid working fluid, and further prevent dry-out of the evaporation capillary structure.

In the present embodiment, the liquid working fluid is contained within the evaporation capillary structure. Due to the thin thickness of the evaporation capillary structure 11, the evaporation liquid film of the working fluid is also thin. According to Fourier's law of heat conduction, the heat transfer rate Q is inversely proportional to the liquid film thickness δ. By reducing the liquid film thickness, the heat transfer rate can be increased, thereby further reducing the evaporation thermal resistance.

The Fourier's law of heat conduction is expressed as follows:

$$Q = \lambda A \frac{dT}{\delta}$$ , wherein Q is the heat transfer rate, A is the heat transfer area, δ is the liquid film thickness, λ is the thermal conductivity of the material, and dT is the temperature difference.

By means of the embodiments of the present disclosure, the flow paths of the vapor working fluid and the liquid working fluid can be separated, reducing the flow resistance of both liquid and vapor, enhancing the circulation efficiency of the working fluid, and thereby improving the heat transfer efficiency of the vapor chamber.

The vapor chamber in the embodiments of the present disclosure can be applied to both horizontal and vertical installation scenarios.

Fig. 6 is a schematic diagram of the structure of a vapor chamber in a vertical installation scenario according to an embodiment of the present disclosure. As shown in Fig. 6, in the vertical installation scenario, in order to overcome the influence of gravity, gather more working fluid directly above the heat source and accelerate the return of liquid working fluid, the "liquid reservoir" within the condensation capillary structure is moved upward and reconfigured as the condensation capillary structure 60 in the vertical direction shown in Fig. 6.

In the present embodiment, the other structures of the vapor chamber are the same as those in the horizontal installation scenario.

According to another embodiment of the present disclosure, a heat dissipation apparatus is also provided, which includes one or more vapor chambers as described in any of the described embodiments.

Further, the heat dissipation apparatus in the embodiment of the present disclosure may be applied to high-power, high-heat-flux density chip cooling scenarios, including but not limited to fields such as telecommunications products, automotive, aerospace, new energy, and consumer electronics cooling.

For specific examples in the present embodiment, reference may be made to the examples described in the foregoing embodiments and exemplary embodiments, and details are not repeatedly described in the present embodiment.

Obviously, those skilled in the art should understand that the modules or steps of the present disclosure can be implemented by general-purpose computing devices. They may be centralized on a single computing device or distributed on a network composed of a plurality of computing devices. They can be implemented by program code executable by computing devices, and thus can be stored in a storage device and executed by the computing devices. Furthermore, in some cases, the shown or described steps may be executed in an order different from that described here, or they are made into integrated circuit modules respectively, or a plurality of modules or steps therein are made into a single integrated circuit module for implementation. As such, the present disclosure is not limited to any particular hardware and software combination.

The foregoing descriptions are merely exemplary embodiments of the present disclosure, but are not intended to limit the present disclosure. For those skilled in the art, the present disclosure may have various modifications and variations. Any modifications, equivalent replacements, improvements and the like made within the principle of the present disclosure shall fall within the scope of protection of the present disclosure.

## Claims

1. A vapor chamber, comprising:

   an evaporation capillary structure;
   a condensation capillary structure, a central thickness of the condensation capillary structure being greater than a peripheral thickness of the condensation capillary structure; and
   a capillary column structure, connected between the evaporation capillary structure and the condensation capillary structure, and used for allowing a liquid working fluid to return to the evaporation capillary structure along the capillary column structure.

2. The vapor chamber according to claim 1, wherein an area of the condensation capillary structure is greater than an area of the evaporation capillary structure.

3. The vapor chamber according to claim 1, further comprising:

   an upper shell, the upper shell being connected to an upper surface of the condensation capillary structure;
   a lower shell, one side of the lower shell being connected to a lower surface of the evaporation capillary structure, and the other side of the lower shell contacting a heat source; and
   a support column, connecting between the lower shell and the upper shell.

4. The vapor chamber according to claim 3, wherein an area of the evaporation capillary structure is greater than an area of the heat source.

5. The vapor chamber according to claim 3, wherein a side of the lower shell contacting the evaporation capillary structure is provided with a groove array structure composed of a plurality of grooves, and the groove array structure being located directly below the evaporation capillary structure.

6. The vapor chamber according to claim 5, wherein an arrangement manner of the groove array structure comprises one of the following: a dotted array, a striped array, or a crossed array; and a shape of the grooves comprises one of the following: triangular, circular, or rectangular.

7. The vapor chamber according to claim 3, wherein a material of the lower shell and the upper shell comprises one of the following: a metal, an alloy, or a composite material.

8. The vapor chamber of claim 3, wherein a sealed cavity is formed between the lower shell and the upper shell.

9. The vapor chamber according to claim 1, wherein the evaporation capillary structure, the capillary column structure, and the condensation capillary structure are made of one of the following:
   sintered copper powder, copper mesh, grooves, or fiber bundles.

10. The vapor chamber according to claim 1, wherein the condensation capillary structure is a truncated pyramid or a truncated cone, wherein an upper surface of the condensation capillary structure is greater than a lower surface of the condensation capillary structure.

11. A heat dissipation apparatus, comprising one or more vapor chambers as claimed in any of claims 1 to 10.

Fig. 1

Fig. 2

Fig. 3

(a)

15

18

(b)

15

18

(c)

15

18

Fig. 4

14    16    13

15    17    11    12

⇧ : heat flow direction    ▮ : liquid path    ⸝ : vapor path

Fig. 5

15    14    17    16    11    60    12

Fig. 6

## INTERNATIONAL SEARCH REPORT

| International application No. |
| --- |
| **PCT/CN2024/092878** |

| A. | CLASSIFICATION OF SUBJECT MATTER |
| --- | --- |

F28D15/04(2006.01)i; H05K7/20(2006.01)i

According to International Patent Classification (IPC) or to both national classification and IPC

| B. | FIELDS SEARCHED |
| --- | --- |

Minimum documentation searched (classification system followed by classification symbols)

IPC:F28D H05K

Documentation searched other than minimum documentation to the extent that such documents are included in the fields searched

Electronic data base consulted during the international search (name of data base and, where practicable, search terms used)

CNABS; CNTXT; WOTXT; EPTXT; USTXT; VEN; IEEE: 均温, 均热, 毛细, 冷凝, 回流, 斜坡, 梯形, 凸台, vapor, capillary, condens+, reflow, incline, trapez+, boss

| C. | DOCUMENTS CONSIDERED TO BE RELEVANT | | |
| --- | --- | --- | --- |
| Category* | Citation of document, with indication, where appropriate, of the relevant passages | | Relevant to claim No. |
| X | US 2007235178 A1 (FUJIKURA LTD.) 11 October 2007 (2007-10-11) description, paragraphs 35-63, and figures 1-6 | | 1-11 |
| A | CN 113437034 A (ZTE CORP.) 24 September 2021 (2021-09-24) entire document | | 1-11 |
| A | CN 114812241 A (GUANGZHOU NEOGENE THERMAL MANAGEMENT TECHNOLOGY CO., LTD.) 29 July 2022 (2022-07-29) entire document | | 1-11 |
| A | CN 209230377 U (NANJING ACME THERMAL ENERGY TECHNOLOGY CO., LTD.) 09 August 2019 (2019-08-09) entire document | | 1-11 |

☐ Further documents are listed in the continuation of Box C.   ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **04 July 2024** | **20 July 2024** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/092878**

| Patent document cited in search report | | | Publication date (day/month/year) | Patent family member(s) | | | Publication date (day/month/year) |
|---|---|---|---|---|---|---|---|
| US | 2007235178 | A1 | 11 October 2007 | US | 2006131002 | A1 | 22 June 2006 |
| | | | | US | 7246655 | B2 | 24 July 2007 |
| | | | | JP | 2006170602 | A | 29 June 2006 |
| | | | | US | 7540319 | B2 | 02 June 2009 |
| CN | 113437034 | A | 24 September 2021 | CN | 113437034 | B | 22 February 2022 |
| | | | | WO | 2023024498 | A1 | 02 March 2023 |
| CN | 114812241 | A | 29 July 2022 | CN | 214502178 | U | 26 October 2021 |
| | | | | WO | 2022161131 | A1 | 04 August 2022 |
| | | | | VN | 99669 | A | 25 December 2023 |
| CN | 209230377 | U | 09 August 2019 | None | | | |

Form PCT/ISA/210 (patent family annex) (July 2022)

## REFERENCES CITED IN THE DESCRIPTION

**Patent documents cited in the description**

- CN 202311053013